Europäisches Patentamt

European Patent Office

Office européen des brevets

(11) Veröffentlichungsnummer: **0 267 391 B1**

(12) **EUROPÄISCHE PATENTSCHRIFT**

(45) Veröffentlichungstag der Patentschrift: **27.12.91**

(51) Int. Cl.⁵: **H03F 3/217**

(21) Anmeldenummer: **87113671.9**

(22) Anmeldetag: **18.09.87**

(54) **Schaltverstärker.**

(30) Priorität: **07.11.86 DE 3637934**

(43) Veröffentlichungstag der Anmeldung:
**18.05.88 Patentblatt 88/20**

(45) Bekanntmachung des Hinweises auf die
Patenterteilung:
**27.12.91 Patentblatt 91/52**

(84) Benannte Vertragsstaaten:
**CH DE FR GB LI**

(56) Entgegenhaltungen:
**EP-A- 0 058 443**
**GB-A- 2 064 901**

(73) Patentinhaber: **Licentia Patent-
Verwaltungs-GmbH
Theodor-Stern-Kai 1
W-6000 Frankfurt/Main 70(DE)**

(72) Erfinder: **Lodahl, Manfred, Dipl.-Ing.
Spindelmühler Weg 6
W-1000 Berlin 45(DE)**

(74) Vertreter: **Schulze, Harald Rudolf, Dipl.-Ing. et
al
Licentia Patent-Verwaltungs-GmbH Theodor-
Stern-Kai 1
W-6000 Frankfurt/Main 70(DE)**

Rank Xerox (UK) Business Services

## Beschreibung

Die Erfindung betrifft einen Schaltverstärker nach dem Oberbegriff des Patentanspruchs 1.

Die Erfindung betrifft insbesondere einen Schaltverstärker, der zur Erzeugung einer amplitudenmodulierten Anodenspannung für einen Hochfrequenz-Hochleistungssender, z.B. einen 500kW-Rundfunksender, geeignet ist. Ein solcher digitaler Leistungsverstärker mit modularem Aufbau zeichnet sich durch einen hohen Wirkungsgrad aus. Sollen solche Verstärker als Niederfrequenzverstärker oder als Modulationsverstärker für Rundfunksender benutzt werden, wobei im letzten Fall noch die Gleichspannungsleistung für die Hochfrequenzendstufe mit zu übertragen ist, so sind die Anforderungen an die Linearität sehr hoch. Es hat sich nun herausgestellt, daß ein aus in Kaskade geschalteten Teilspannungsquellen bestehender Schaltverstärker sehr viele störende Kapazitäten besitzt, die durch den Aufbau der Teilspannungsquellen bedingt sind und die durch wirtschaftlich vertretbare Maßnahmen nicht zu beseitigen sind. Die störenden Kapazitäten verschlechtern in nachteiliger Weise die Linearität des Schaltverstärkers.

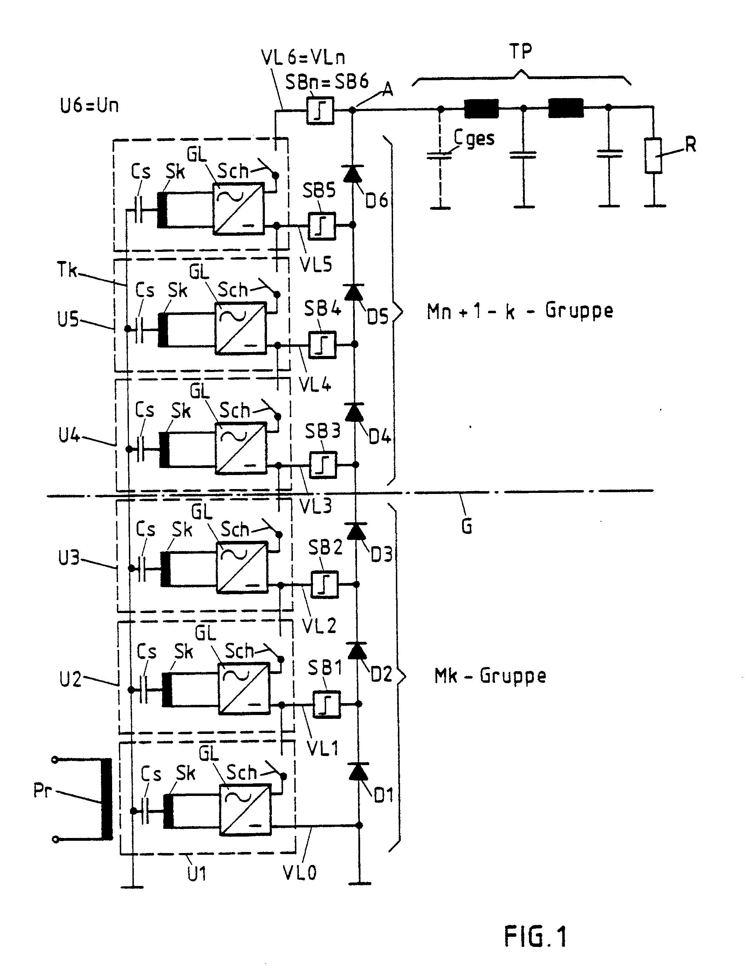

Figur 1 zeigt in einer schematischen Darstellung den prinzipiellen Aufbau eines solchen Schaltverstärkers. Aus einem Netztransformator mit einer Primärwicklung Pr, z.B. für ein 380V, 50Hz-Drehstromnetz, einem Transformatorenkern Tk, mehreren Sekundärwicklungen Sk, mehreren Gleichrichteranordnungen Gl sowie mehreren Schaltern Sch werden schaltbare Teilspannungsquellen U1 bis Un gebildet, wobei in dem dargestellten Beispiel n = 6 gewählt ist. Die Teilspannungsquellen U1 bis Un sind über Verbindungsleitungen VL0 bis VLn mit den zugehörigen Dioden D1 bis Dn einer Diodenkaskade verbunden, deren ein Ende mit Masse (Null-Potential) verbunden ist und an deren anderem Ende eine Tiefpaßanordnung TP, die z.B. als sogenanntes Pi-Filter aus Induktivitäten und Kondensatoren aufgebaut ist, angeschlossen ist. An dem Ausgang der Tiefpaßanordnung ist eine Last R angeschlossen, z.B. die Anode einer Senderendstufenröhre eines Rundfunk-Hochleistungssenders. Ein solcher Schaltverstärker wird auch als Modulationsverstärker bezeichnet. Mit Hilfe einer nicht dargestellten Steuerschaltung ist es möglich, die Teilspannungsquellen U1 bis Un derart in Reihe zu schalten, daß an der Last R eine Ausgangsspannung, z.B. eine Gleichspannung mit einem Maximalwert von 30kV, entsteht. Diese Ausgangsspannung entspricht z.B. der an dem Eingang der Steuerschaltung anliegenden Steuerspannung, z.B. einem Niederfrequenz (NF) - Signal mit einer Bandbreite von 5 kHz. In dem Beispiel sind die störenden schädlichen Kapazitäten $C_s$ symbolisch zwischen den Sekundärwicklungen des Speisetransformators und seinem auf Erdpotential liegenden Transformatorkern dargestellt.

In der europäischen Patentanmeldung EP-A1 0 058 443 ist ein Weg gewiesen, den schädlichen Einfluß von unerwünschten Kapazitäten zwischen der Sekundär- und der Primärwicklung von Impulsübertragern zu mildern, da das Umladen mit relativ großen Verlustleistungen verbunden ist. Dies wird dadurch erreicht, daß bei einem Schaltverstärker mit mehreren Schaltstufen von der Pulsbreitenmodulation aller Stufen abgegangen wird und ein Verfahren vorgeschlagen wird, bei dem die Einschaltdauer der Schaltstufen verlängert und dafür die Anzahl der einzuschaltenden Schaltstufen verringert wird. Die Ausgangsspannung aller eingeschalteten Schaltstufen ist dabei gleich groß. Es werden nur so viele Schaltstufen eingeschaltet, wie es zur Darstellung des gewünschten Ausgangssignals erforderlich ist. Mit einer solchen Änderung ist zwar die Verlustleistung, hervorgerufen durch das Umladen von unerwünschten Kapazitäten, vermindert, jedoch sind diese Verlustleistungen von der Signalamplitude abhängig, was Verzerrungen des Ausgangssignales zur Folge hat.

In der deutschen Offenlegungsschrift DE-A-30 44 956 ist ein Verstärker der beschriebenen Art angegeben, wobei zur feineren Unterteilung der Ausgangsspannung neben Grobstufen auch noch Feinstufen existieren. Entsprechend einem zu verstärkenden Modulationssignal soll in zeitlicher Abfolge die notwendige Anzahl von Grob- und Feinstufen ein bzw. ausgeschaltet werden.

Die einzelnen Teilspannungsquellen nehmen im Betriebsfall wegen des digitalen Charakters der Verstärkers je nach Modulationssignal ständig sich ändernde unterschiedliche Potentiale an. Die Folge ist ein wechselseitiges Auf- und Entladen der in Fig. 1 dargestellten schädlichen Kapazitäten $C_s$. Diese schädlichen Kapazitäten haben von der schaltungstechnischen Zuordnung der zugehörigen Teilspannungsquelle und von dem Schaltzustand anderer Teilspannungsquellen abhängige Spannungen und damit Ladungen. Bei den Schaltvorgängen werden somit je nach Orts- und Spannungsabhängigkeit der jeweiligen schädlichen Kapazität unterschiedliche Ladungsmengen in ihnen gespeichert oder freigesetzt. Gleiche Spannungsänderungen haben daher ungleiche Gesamtladungsänderungen der schädlichen Kapazitäten $C_s$ zur Folge. Ihr Vorhandensein bewirkt somit bei der in der Zitierten Offenlegungsschrift angegebenen Betriebsweise erhebliche Verzerrungen, was sich in einem hohen Klirrfaktor des Ausgangssignals auswirkt.

Man kann ersatzweise für alle schädlichen Kapazitäten eine Ersatz-Gesamtkapazität $C_{ges}$ am Ausgang der Teilspannungskaskade, d.h. am Eingang des Tiefpaßfilters der Verstärkerschaltung, angeben. Diese ist nach dem vorher Gesagten eine spannungsabhängige Kapazität, die störende, Verzerrungen des Ausgangssignales bewirkt.

Der Erfindung liegt die Aufgabe zugrunde, einen gattungsgemäßen Schaltverstärker dahingehend zu verbessern, daß die störenden Kapazitäten im wesentlichen spannungsunabhängig sind.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein Vorteil der Erfindung besteht darin, daß die entstandene, im wesentlichen spannungsunabhängige Summe der störenden Kapazitäten $C_s$ nun als Gesamtkapazität $C_{ges}$ für die Tiefpaßanordnung TP nutzbar ist. Die Gesamtkapaziät $C_{ges}$ ist damit einem tatsächlich vorhandenen Kondensator der Tiefpaßanordnung TP gleichsetzbar und daher für die Auslegung der gewünschten Filtercharakteristik verwendbar.

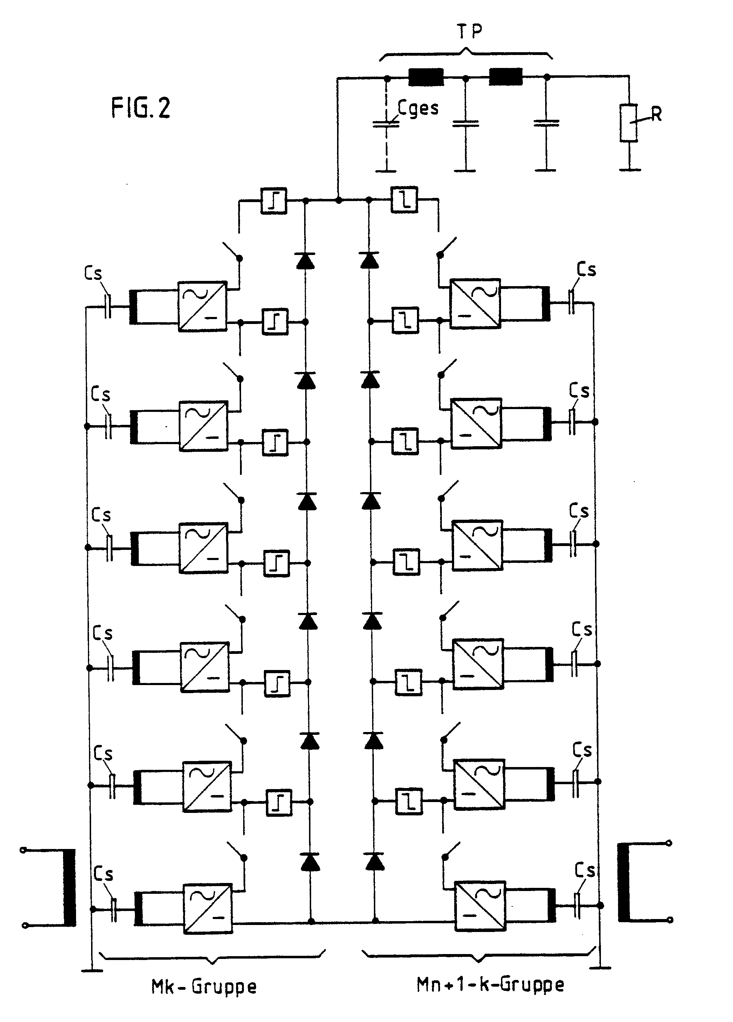

Die Erfindung wird im folgenden anhand von Ausführungsbeispielen unter Bezugnahme auf weitere schematische Figuren näher erläutert. Die Figuren 2 bis 5 zeigen Ausführungsbeispiele.

Die Erfindung beruht darauf, daß es mit einer speziell gestalteten Steuereinheit gelingt, die Teilspannungsquellen U1 bis Un (Fig.1) in Abhängigkeit von dem an der Steuereinheit anliegenden Modulationssignal, z.B. einem zu verstärkenden NF-Signal mit einer Bandbreite von 5kHz, so ein- oder auszuschalten, daß die am Eingang der Tiefpaßanordnung TP liegende, an sich störende Gesamtkapazität $C_{ges}$ spannungsunabhängig wird und somit rechnerisch als Teil der Filteranordnung berücksichtigt werden kann. Damit sind Verzerrungen aufgrund des Vorhandenseins der schädlichen Kapazitäten $C_s$ beseitigt.

Es ist notwendig, daß immer eine geradzahlige Anzahl n von in Reihe geschalteten Teilspannungsquellen U1 bis Un vorhanden ist. Dies werden gemäß Fig. 1 in zwei gleich große Gruppen $M_k$ und $M_{n+1-k}$ aufgeteilt. Beispielsweise gehören bei n = 6 die Teilspannungsquellen U1 bis U3 zu der $M_k$-Gruppe und die Teilspannungsquellen U4 bis U6 zu der $M_{n+1-k}$-Gruppe. Dabei sind die Teilspannungsquelle U1 und die Last R einseitig an Masse gelegt (geerdet). Die Teilspannungsquelle U6 ist über die Verbindungsleitung VL6 an den Ausgang A angeschlossen. Eine spannungsunabhängige Gesamtkapazität $C_{ges}$ wird erreicht durch ein paarweises komplementäres gleichsinniges Ein- oder Ausschalten der Teilspannungsquellen U1 bis Un. Das heißt, bezüglich der Grenze G zwischen der $M_k$-Gruppe und der $M_{n+1-k}$-Gruppe werden immer zwei komplementär angeordnete Teilspannungsquellen, z.B. U3 und U4, dann U1 und U6, eingeschaltet, dann z.B. U3 und U4 ausgeschaltet. Die Wirkungsweise eines derartigen Schaltschemas wird im folgenden näher erläutert:

Es wird angenommen, daß jede Teilspannungsquelle denselben Spannungssprung $\Delta U$ erzeugt. Am Ausgang A kann daher die Maximalspannung 6 · $\Delta U$ entstehen. Wird nun lediglich eine einzige Teilspannungsquelle, z.B. U2, eingeschaltet, so ergibt sich am Ausgang A ein Spannungssprung $\Delta U$ mit der Folge, daß sämtliche Kapazitäten $C_s$ oberhalb der eingeschalteten Teilspannungsquelle, also U3 bis U6, jeweils die Ladungsmenge $Q = C_s \cdot \Delta U$ speichern.

Bei einer paarweisen komplementären Einschaltung der Teilspannungsquellen sind dagegen bei n/2-Einschaltungen sämtliche Teilspannungsquellen U1 bis Un eingeschaltet. Bezeichnet k die Einschaltzahl, so kann k die Werte 1 bis n/2 annehmen. Bei einem komplementären Schaltvorgang werden immer die Teilspannungsquellen $U_k$ und $U_{n+1-k}$ gleichsinnig geschaltet, so daß ein Spannungssprung $\pm 2 \cdot \Delta U$ entsteht. Die schädlichen Kapazitäten $C_s$ nehmen bei dem k-ten Schaltvorgang die folgende Ladungsmenge $Q_{k,n+1-k}$ auf:

$$Q_{k,n+1-k} = Q_k + Q_{n+1-k}$$
$$Q_k = (n-k) \cdot C_s \cdot \Delta U$$
$$Q_{n+1-k} = (n- (n+1-k)) \cdot C_s \cdot \Delta U = (k-1) \cdot C_s \Delta U$$
$$Q_{k,n+1-k} = (n-k + k-1) \cdot C_s \cdot \Delta U = (n-1) \cdot C_s \cdot \Delta U$$

Aus der letzten Formel ist ersichtlich, daß bei einem komplementären Schaltvorgang die Ladungsmenge $Q_{k,n+1-k}$ nicht von der Spannung U abhängt, sondern nur von dem Spannungssprung $\Delta U$. Da sich bei jedem Schaltvorgang, wie bereits erwähnt, eine Spannungsänderung von 2 · $\Delta U$ ergibt, folgt aus der letzten Formel:

$$Q_{k,n+1-k} = \tfrac{1}{2} (n-1) \cdot C_s \cdot 2 \Delta U$$

das heißt, die wirksame Gesamtkapazität $C_{ges}$ bei einem Spannungssprung von 2 · $\Delta U$ beträgt:

$$C_{ges} = \tfrac{1}{2} (n-1) \cdot C_s.$$

Aus dieser Formel folgt, daß $C_{ges}$ in erwünschter Weise unabhängig von der bereits vorhandenen Spannung U und der Lage der Teilspannungsquelle (gekennzeichnet durch k) ist. $C_{ges}$ kann daher in einfacher Weise in die Berechnung der Filteranordnung TP einbezogen werden.

Zur Vermeidung hoher und störender Kommutierungsströme bei den Schaltvorgängen sind in den Verbindungsleitungen VL1 bis VLn außerdem Strombegrenzer SB1 bis SBn vorhanden, die in der nicht vorveröffentlichten EP-A-0 218 152 (veröffentlicht am 15.4.1987) näher beschrieben sind.

Das Ausführungsbeispiel gemäß Fig. 2 unterscheidet sich von demjenigen gemäß Fig. 1 lediglich dadurch, daß die $M_k$-Gruppe und die $M_{n+1-k}$-Gruppe parallelgeschaltet sind. Auch hier ergibt sich für die zu speichernde Gesamtladung bei dem k-ten Schaltvorgang

$$Q_{k,n+1-k} = (n-1) \cdot C_s \cdot \Delta U.$$

Da bei dieser Parallelschaltung bei jedem Schaltvorgang lediglich ein Spannungssprung $\Delta U$ auftritt, ergibt sich für die spannungsunabhängige Gesamtkapazität $C_{ges}$:

$$C_{ges} = (n-1) \cdot C_s$$

Die Anzahl der Schaltvorgänge bis zu der Vollaussteuerung (maximale Ausgangsspannung) beträgt k = 1... n, wobei n eine gerade Zahl ist die der Anzahl der Teilspannungsquellen entspricht.

Soll der Spannungssprung $\Delta U$ bzw. $2 \cdot \Delta U$ feiner unterteilt werden, z.B. mit einer binären Gewichtung, so sind gemäß den Ausführungsbeispielen der Fig. 1 und 2 zwei entsprechende Feinstufen-Schaltungsanordnungen erforderlich. Diese können z.B. die Teilspannungsquellen U1 und Un ersetzen.

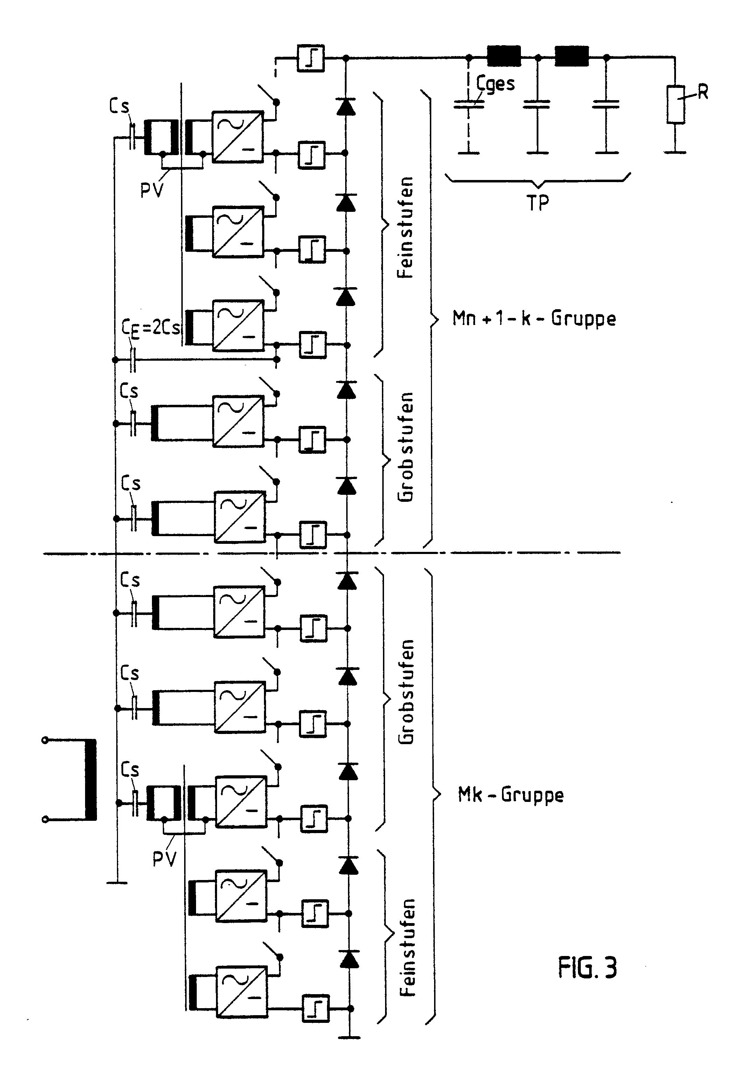

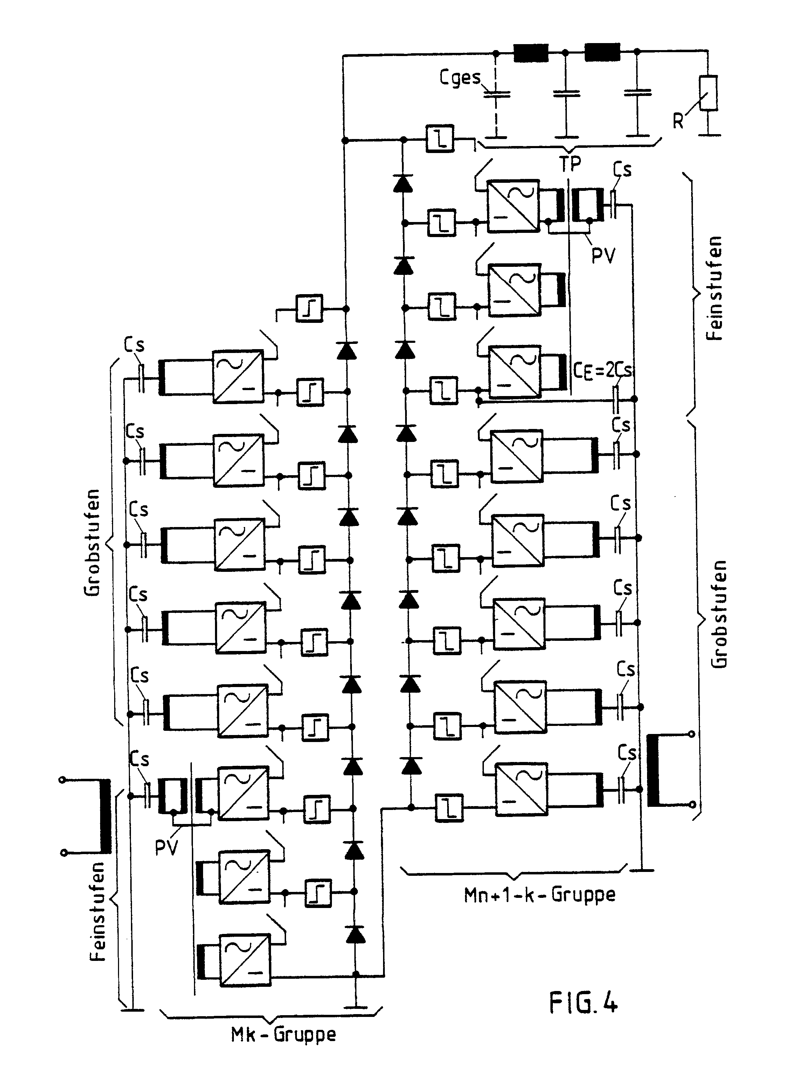

Solche Anordnungen sind in dem Fig. 3 (Reihenschaltung der $M_k$ und der $M_{n+1-k}$-Gruppe) und Fig. 4 (Parallelschaltung der $M_k$- und der $M_{n+1-k}$-Gruppe) dargestellt.

Die Gesamtkapazität $C_{ges}$ bleibt auch bei Einbeziehung der Feinstufen im wesentlichen spannungsunabhängig und von dem Schaltvorgang k unabhängig, wenn zum einen die kleinste binäre Teilspannungsquelle potentialmäßig als oberste Teilspannungsquelle angeordnet wird und eine Potentialverbindung PV zwischen Primär- und Sekundärwicklung des Speisetransformators der Frinstufenanordnung hergestellt wird, d.h. eine Potentialverbindung zur zugehörigen schädlichen Kapazität für die Feinstufenanordnung geschaffen wird - und zum anderen an bestimmten Stellen mindestens eine Ergänzungskapazität $C_E$, die z.B. den Wert $C_E = 2C_s$ besitzt, hinzugefügt wird. In den Beispielen gemäß den Fig. 3 und 4 wurden diese Ergänzungskapazitäten $C_E$ unterhalb der oberen Feinstufenanordnungen gegen Masse (Erdpotential) geschaltet.

In der Reihenschaltung der Komplementärgruppen (Fig. 3) muß von der Feinstufenanordnung der Spannungsbereich $2 \cdot \Delta U$ abgedeckt werden; bei der Parallelanordnung (Fig.4) ist dies nur $\Delta U$. Die Reihenfolge der Schaltvorgänge ist beliebig und kann damit z.B. nach Belastungskriterien für die einzelnen Teilspannungsquellen festgelegt werden. Wichtigste Voraussetzung für $C_{ges}$ = konst. ist das paarweise komplementäre Ein- bzw. Ausschalten der Teilspannungsquellen.

Sind die Anforderungen an die Linearität der Verstärkeranordnung nicht so hoch, so können die komplementären Spannungsquellen in der Reihenanordnung der Komplementärgruppen auch nacheinander ein- und ausgeschaltet werden, wodurch die zweifach großen Spannungssprünge $(2 \cdot \Delta U)$ vermieden werden.

In der bereits erwähnten EP-A-0 218 152 (veröffentlicht am 15.4.1987 ist ein digital arbeitender Schaltverstärker für Gleich-und Wechselspannung beschrieben, der über eine Reihe von schaltungstechnischen und steuerungstechnischen Maßnahmen verfügt, die der linearen Verstärkung dienen. Die Einzelheiten der in dieser Patentanmeldung angegebenen Schaltungsmaßnahmen werden hier nicht noch einmal beschrieben, sie sind jedoch in vollem Umfang auf den hier beschriebenen digitalen Leistungsverstärker mit komplementärer Teilspannungs-Steuerung anwendbar.

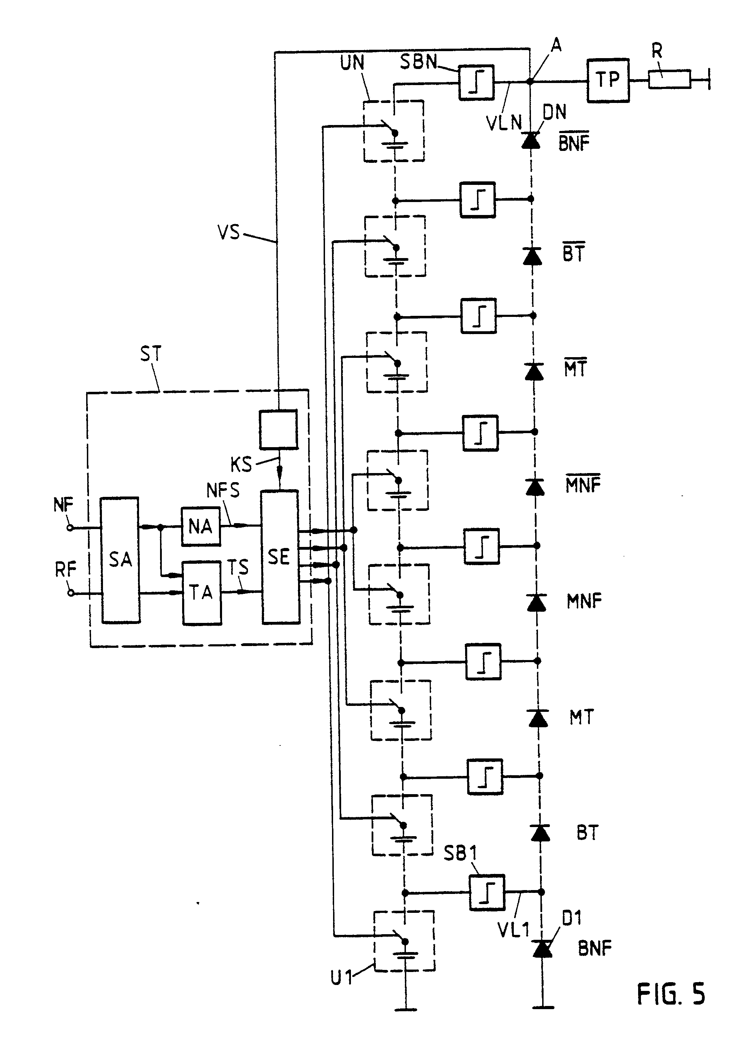

Fig. 5 zeigt in Anlehnung an den Schaltverstärker gemäß der EP-A-0 218 152 (veröffentlicht 15.4.1987) das Blockschaltbild eines Schaltverstärkers, der zusätzlich über eine komplementäre Steuerung der Teilspannungsquellen verfügt.

Die Modifizierung ist dadurch bewirkt, daß aus der Maximal-Trägergruppe (MT) und der Maximal-Niederfrequenzgruppe (MNF) jeweils zusätzliche Komplementärgruppen $\overline{MT}$ bzw. $\overline{MNF}$ gebildet werden.

Als Feinstufenanordnung wird für die Binär-Niederfrequenzgruppe (BNF) eine Zweimal-Binäranordnung (BNF; $\overline{BNF}$) entsprechend dem komplementären Steuerungsprinzip vorgesehen.

Als Feinstufenanordnung für die Binär-Trägergruppe (BT) wird ebenfalls eine Zweimal-Binäranordnung (BT; $\overline{BT}$) vorgesehen. Da die Trägerspannungssteuerung nur geringen Einfluß auf die Linearität des Verstärkers hat, genügt hier eine Einmal-Binäranordnung mit doppeltem Spannungshub. Diese Feinstufenanordnung ist dann vorzugsweise am oberen Ende der Teilspannungskaskade anzuordnen. In Fig. 5 ist eine beispielhafte Steuerungsanordnung ST dargestellt, die zur Steuerung der komplementären Teilspannungsquellen geeignet ist.

## Patentansprüche

1. Schaltverstärker, bestehend aus mehrere in Kaskade geschalteten Teilspannungsquellen $U_1$ bis $U_n$ (U1,U2,...), einer an den Ausgang der Kaskade angeschlossenen Tiefpaßanordnung (TP), an deren Ausgang ein Lastwiderstand (R) anschließbar ist, sowie einer Steuerschaltung (ST) zum Schalten der Teilspannungsquellen $U_1$ bis $U_n$ in Abhängigkeit von einem an der Steuerschaltung (ST) anliegenden Eingangssignal (NF), insbesondere zur Erzeugung einer amplitudenmodulierten Anodenspannung für einen Hochfrequenz-Hochleistungssender,
dadurch gekennzeichnet,

- daß eine gerade Anzahl von Teilspannungsquellen vorhanden ist, n somit gerade ist,
- daß die Teilspannungsquellen in zwei gleichgroße Komplementärgruppen $M_k$ und $M_{n+1-k}$ aufgeteilt sind und
- daß die Steuerschaltung (ST) derart ausgebildet ist, daß bei jedem Schaltvorgang im wesentlichen gleichzeitig immer zwei komplementär angeordnete Teilspannungsquellen $U_k$ und $U_{n+1-k}$ gleichsinnig schaltbar sind, wobei der Index k eine geschaltete Teilspannungsquelle der $M_k$ Gruppe und der Index n+1-k die gleichzeitig geschaltete komplementäre Teilspannungsquelle der $M_{n+1-k}$-Gruppe kennzeichnet, wobei gilt k = 1,2,...,n.

2. Schaltverstärker nach Anspruch 1, dadurch gekennzeichnet, daß die Komplementärgruppen $M_k$ und $M_{n+1-k}$ zu einer Reihenschaltung zusammengeschaltet sind.

3. Schaltverstärker nach Anspruch 1, dadurch gekennzeichnet, daß die Komplementärgruppen $M_k$ und $M_{n+1-k}$ zu einer Parallelschaltung zusammengeschaltet sind.

4. Schaltverstärker nach einem der vorhergehenden Ansprüche, dadurch gekennzeichnet, daß zur Feinstufung der Ausgangsspannung Feinstufenanordnungen mit vorzugsweiser binärer Wichtung vorgesehen sind, wobei jeder Komplementärgruppe mindestens eine Feinstufenanordnung zugeordnet ist.

5. Schaltverstärker nach einem der vorhergehenden Ansprüche, dadurch gekennzeichnet, daß zumindest bei den Feinstufenanordnungen mindestens ein Schaltungsmittel ($C_E$,PV) vorhanden ist, das eine im wesentlichen spannungsunabhängige Gesamtkapazität ($C_{ges}$) bewirkt.

6. Schaltverstärker nach Anspruch 5, dadurch gekennzeichnet, daß das Schaltungsmittel als zusätzliche Kapazität ($C_E$) und/oder als Potentialverbindung (PV) ausgebildet ist.

7. Schaltverstärker nach einem der vorhergehenden Ansprüche, dadurch gekennzeichnet, daß mindestens eine Teilspannungsquelle über einen Strombegrenzer (SB) mit der Diodenkaskade (D1 bis DN) verbunden ist.

## Claims

1. Switching amplifier consisting of several partial voltage sources $U_1$ to $U_n$ (U1, U2 ...) connected in cascade, a low-pass filter arrangement (TP), which is connected to the output of the cascade and to the output of which a load resistor (R) is connectable, as well as of a control circuit (ST) for the switching of the partial voltage sources $U_1$ to $U_n$ in dependence on an input signal (NF) present at the control circuit (ST), in particular for the generation of an amplitude-modulated anode voltage for a high-frequency high-power transmitter, characterised thereby, that an even number of partial voltage sources is present, n thus being even, that the partial voltage sources are divided up into two equally large complementary groups $M_k$ and $M_{n+1-k}$ and that the control circuit (ST) is constructed in such a manner that two complementarily arranged partial voltage sources $U_k$ and $U_{n+1-k}$ are always switchable in like sense substantially at the same time during each switching operation, wherein the index k characterises a switched partial voltage source of the $M_k$ group and the index n+1-k characterises the simultaneously switched complementary partial voltage source of the $M_{n+1-k}$ group, wherein k = 1, 2, ...,n.

2. Switching amplifier according to claim 1, characterised thereby, that the complementary groups $M_k$ and $M_{n+1-k}$ are connected together into a series connection.

3. Switching amplifier according to claim 1, characterised thereby, that the complementary groups $M_k$ and $M_{n+1-k}$ are connected together into a parallel connection.

4. Switching amplifier according to one of the preceding claims, characterised thereby, that fine step arrangements with preferably binary weighting are provided for the fine graduation of the output voltage, wherein at least one fine step arrangement is associated with each complementary group.

5. Switching amplifier according to one of the preceding claims, characterised thereby, that at least one switching means ($C_E$, PV), which effects a total capacitance ($C_{ges}$) substantially independent of voltage, is present at least in the fine step arrangements.

6. Switching amplifier according to claim 5, characterised thereby, that the switching means is constructed as additional capacitor

($C_E$) and/or as potential connection (PV).

7. Switching amplifier according to one of the preceding claims, characterised thereby, that at least one partial voltage source is connected by way of a current limiter (SB) with the diode cascade (D1 to DN).

## Revendications

1. Amplificateur à commutation, constitué de plusieurs sources de tension partielles $U_1$ à $U_n$ - (U1, U2...) montées en cascade, d'un dispositif de filtre passe-bas (TP) raccordé à la sortie de la cascade et à la sortie duquel peut être raccordée une résistance de charge (R), ainsi que d'un circuit de commande (ST) pour connuter les sources de tension partielles $U_1$ à $U_n$ en fonction d'un signal d'entrée (BF) appliqué au circuit de commande (ST), en particulier pour générer une tension d'anode modulée en amplitude pour un émetteur haute fréquence de grande puissance, caractérisé en ce

   - qu'il comprend un nombre pair de sources de tension partielles, de sorte que n est pair,
   - que les sources de tension partielles sont partagées en deux groupes complémentaires de même grandeur $M_k$ et $M_{n+1-k}$ et
   - que le circuit de commande (ST) est réalisé de manière qu'à chaque opération de commutation, deux sources de tension partielles $U_k$ et $U_{n+1-k}$, disposées de façon complémentaire, puissent être commutées toujours dans le même sens, essentiellement en même temps, l'indice k caractérisant une source de tension partielle commutée du groupe $M_k$ et l'indice n+1-k caractérisant la source de tension partielle complémentaire, commutée en même temps, du groupe $M_{n+1-k}$, où k = 1,2, ..., n.

2. Amplificateur à commutation selon la revendication 1, caractérisé en ce que les groupes complémentaires $M_k$ et $M_{n+1-k}$ sont connectés ensemble en un montage en série.

3. Amplificateur à commutation selon la revendication 1, caractérisé en ce que les groupes complémentaires $M_k$ et $M_{n+1-k}$ sont connectés ensemble en un montage en parallèle.

4. Amplificateur à commutation selon une des revendications précédentes, caractérisé en ce que, pour l'étagement fin de la tension de sortie, on a prévu des systèmes d'étages fins, de préférence à pondération binaire, avec coordination d'au moins un système d'étages fins à chaque groupe complémentaire.

5. Amplificateur à commutation selon une des revendications précédentes, caractérisé en ce qu'au moins les systèmes d'étages fins comportent au moins un moyen de commutation ($C_E$, PV) produisant une capacité globale ($C_{ges}$) essentiellement indépendante de la tension.

6. Amplificateur à commutation selon la revendication 5, caractérisé en ce que le moyen de commutation est réalisé comme une capacité supplémentaire ($C_E$) et/ou comme une connexion de potentiel (PV).

7. Amplificateur à commutation selon une des revendications précédentes, caractérisé en ce qu'au moins une source de tension partielle est reliée à travers un limiteur de courant (SB) à la cascade de diodes (D1 à Dn).

FIG.1

FIG.2

TP

Cges

R

Cs

Cs

Cs

Cs

Cs

Cs

Cs

Cs

Cs

Cs

Cs

Cs

Mk-Gruppe

Mn+1-k-Gruppe

EP 0 267 391 B1

FIG. 3

9

FIG. 4

FIG. 5